# EUROPEAN PATENT APPLICATION

(11) **EP 1 095 766 A2**
(43) Date of publication of application: **02.05.2001**
(21) Application number: 00309545.2
(22) Date of filing: 30.10.2000
(51) Int. Cl.: B32B 31/20, H05K 3/00

(54) **Apparatus and method for vacuum lamination of adhesive film**

(30) Priority: 28.10.1999 JP 30709099
(71) Applicant: Ajinomoto Co., Inc., Tokyo 104-8315 (JP)
(72) Inventor: Nakamura, Shigeo, c/o Aminoscience Laboratories, Kawasaki-shi, Kanagawa-ken 210-8681 (JP)
(74) Representative: Nicholls, Kathryn Margaret

(57) **Abstract**

Herein is disclosed an apparatus for vacuum lamination of an adhesive film wherein the resin composition layer of an adhesive film is vacuum laminated continuously on the patterned part of a circuit board by heating and pressing conditions with the use of a heat-resistant rubber roll, said heat-resistant rubber roll being wider than said adhesive film, and having concave parts or notch parts corresponding to the width of the adhesive film to be placed and on the surfaces in the vicinity of both the ends of the roll. The present invention relates to an apparatus and method for vacuum lamination of an adhesive film wherein the problem of fouling a laminating roll caused by the seepage of the resin composition from an adhesive film for circuit board lamination can be obviated, whereby the problem of fouling a laminating roll caused by the seepage of the resin composition from an adhesive film for circuit board lamination at the lamination can be solved.

## Description

The present invention relates to an apparatus and method for vacuum lamination of adhesive film. It may be suitable for use in a process for manufacturing a multilayer printed-wiring board of the build-up type which is formed by alternately stacking conductor circuitry layers and insulating layers, wherein it may be used for vacuum laminating an adhesive film on an internal-layer circuit.

As a process for manufacturing a multilayer printed-wiring board, attention has recently been focused on the build-up type technique wherein an organic insulating layer is formed alternately on a conductor layer of an internal-layer circuit board. Japanese Patent Application Laid-Open (Kokai) No. 64960/1996 discloses a process for manufacturing a multilayer printed-wiring board comprising the steps of applying an undercoat adhesive, drying it preliminarily, bonding an additive adhesive in the film form thereto, curing it under heating, roughening it with an alkaline oxidizing agent and forming a conductor layer by plating. The present inventors have also disclosed an interlayer adhesive film for a multilayer printed-wiring board, capable of simultaneously performing the covering of an internal-layer circuit pattern and resin filling into a surface via hole and/or a through-hole, and a process for manufacturing a multilayer printed-wiring board by the use of the same. In the case of vacuum lamination of the adhesive film placed between two sheets of heat-resistant rubber under heating and pressing conditions, there are advantages of an excellent filling ability of the adhesive into the internal-layer circuit and superior productivity owing to the unnecessity of an undercoating step. However, since the adhesive has excellent thermal flowability, there is the problem that the adhesive seeps from the edges of the adhesive film and makes dirty the press surface or the laminating roll.

Preferred embodiments of the present invention may provide an apparatus and method for preventing the fouling of a laminating roll caused by seepage of the adhesive even in an apparatus at which a roll-shape adhesive film is vacuum laminated continuously by the use of a heat-resistant rubber roll.

A first embodiment of the present invention relates to an apparatus for the vacuum lamination of an adhesive film wherein the resin composition layer of an adhesive film comprising a supporting base film and a resin composition layer which is thermally flowable and solid at room temperature, which is laminated on the surface of the base film and which has a width and an area substantially equal to those of the base film is vacuum laminated continuously onto a lamina, eg the patterned part of a circuit board, under heating and pressing conditions by the use of a heat-resistant rubber roll wider than said adhesive film,
(a) said heat-resistant rubber roll having concave parts or notch parts corresponding to the width of the adhesive film to be placed and on the surfaces in the vicinity of both the ends of the roll, and
(b) said concave parts having a depth of at least 0.5 mm, its inner walls being respectively positioned at a distance within a range of 1 to 20 mm toward the inside from both the edges of the adhesive film, its outer walls being respectively positioned at a distance of at least 1 mm toward the outside, or the walls of said notch parts being respectively positioned at a distance within a range of 1 to 20 mm toward the inside from both the edges of the adhesive film.

And, a second embodiment of the present invention relates to a method for preventing the seepage of the resin composition from an adhesive film wherein the resin composition layer of the adhesive film comprising a supporting base film and a resin composition layer which is thermally flowable and solid at room temperature, which is laminated on the surface of the base film and which has a width and an area substantially equal to those of the base film is continuously vacuum laminated, eg on the patterned part of a circuit board, under heating and pressing conditions by the use of a heat-resistant rubber roll wider than said adhesive film, said method comprising the steps of
(a) positioning the concave parts having a width of 2 to 21 mm and a depth of at least 0.5 mm or notch parts having a depth of at least 0.5 mm provided on the surfaces in the vicinity of both the ends of said heat-resistant rubber roll in such way that the inner walls of the concave parts or the walls of the notch parts are positioned on the outside of the patterned part of the circuit board,
(b) positioning both the edges of said adhesive film always on the outside of the inner wall of each concave part or the wall of each notch part, and in the case of the concave part, positioning both the edges of said adhesive film at least 1 mm away toward the inside from the outer wall of each concave part, and then
(c) vacuum laminating the adhesive film.

### DETAILED DESCRIPTION OF THE INVENTION

The resin composition which forms a thermally flowable resin composition layer solid at room temperature and is to be used according to the present invention is not particularly limited so long as it softens upon heating, has film-forming ability and satisfies the properties required for an interlayer insulating material, such as heat-resistance and electrical properties when thermally cured at a high temperature. The thickness of the resin composition layer is at least the conductor thickness of the internal-layer circuit board to be laminated and generally, in the range of 10 to 120 µm thicker than the conductor thickness.

Examples of the resin composition include epoxy resin types, acrylic resin types, polyimide resin types, polyamideimide resin types, polycyanate resin types, polyester resin types, thermosetting polyphenyleneether resin types, and the like. It is possible to employ a combination of two or more of them or to form an adhesive film having a multilayer structure. Among them, an epoxy resin composition disclosed in Japanese Patent Application No. 357420/1997 (Jap. Pat. Appln. Laid-open (Kokai) No. 87927/1999) can be mentioned out of the epoxy resin types which are excellent in reliability and cost as the interlayer insulator.

The adhesive film to be used according to the present invention can be manufactured by applying a resin varnish dissolved in a prescribed solvent onto the surface of a supporting base film and evaporating the solvent through heating and/or exposing to a hot air blast according to a known and usual method. Examples of the supporting base film include a polyolefin such as polyethylene, polyvinyl chloride, or the like, a polyester such as polyethylene terephthalate, or the like, a polycarbonate, release paper, metal foil such as copper foil or aluminum foil, or the like. The thickness of the supporting base film is generally in the range of 10 to 150 µm. The supporting base film can be those ones which have been subjected to a mat treatment and a corona treatment as well as a peelable treatment.

The adhesive film to be used according to the present invention comprising the resin composition and the supporting base film is stored as it is or after further laminating a protective film on the surface of the resin composition layer, with winding up into a roll. Examples of the protective film include polyolefins such as polyethylene, polypropylene and the like and release paper, and the thickness of the film is preferably in the range of 5 to 50 µm. Thereafter, the adhesive film is cut into a predetermined width by slit processing, while the area of the resin composition layer becomes substantially equal to that of the supporting film.

For continuous vacuum lamination of the resin composition layer of the adhesive film wound as a roll on a patterned circuit board under heating and pressing conditions with the use of a heat-resistant rubber roll, a commercially available vacuum laminating machine such as a vacuum roll-type dry coater manufactured by Hitachi Techno-Engineering Co., Ltd. or a fast vacuum laminator manufactured by Taisei-Laminator Co., Ltd. can be employed. In the case where a protective film is present on the adhesive film, the resin composition layer is laminated by heating and pressing from the supporting base film side with winding off the protective film under vacuum. Good covering of an internal-layer circuit pattern can be effected by laminating under such condition that the resin flow is, upon laminationg, at least the conductor thickness of the internal-layer circuit. More specifically, it is preferable to perform the lamination at a laminating temperature of 70 to 140°C and a linear pressure of 1 to 10 kgf/cm, under a reduced pressure of 8 kPa or less, and at a transferring rate of 0.2 to 2 m/minute, with the film and circuit board being preheated if necessary.

When a circuit board is wider than an adhesive film, the resin composition (adhesive) seeps out of the edges of the adhesive film, and the seeping resin adheres, as is seen in the prior art, to the laminating roll. As compared therewith, according to the present invention, the lamination is performed with the use of a heat-resistant rubber roll around the outer parts of which concave parts are provided at a width of 1 to 20 mm toward the inside and at least 1 mm toward the outside from both the edges of the adhesive film and a depth of at least 0.5 mm. Thereby, since the edge parts of the adhesive film scarcely receive rolling pressure, the resin composition hardly seeps out, so that continuous lamination can be effected clean. When both the inward and outward widths of each concave part are less than 1 mm from both the edges of the adhesive film, the positioning of the edges of the adhesive film becomes difficult, and whereas, when the inward width exceeds 20 mm, the rubber is crushed to result in no effect of its removal. In addition, when the concave part does not have a depth of at least 0.5 mm, a pressure-reducing effect near the edge parts of the adhesion film expected from the removal is diminished owing to the crush of the rubber. More specifically, the depth is not more than the thickness of the rubber and can be determined depending on the thickness and hardness of the heat-resistant rubber to be used and laminating conditions. The formation of the concave parts can be effected by subjecting the roll to a processing for removal such as scraping of the heat-resistant rubber in the range of the concave parts or by additionally putting the heat-resistant rubber around the roll so as to form inward convex shapes.

The apparatus and method for vacuum laminating an adhesive film on a patterned circuit board according to the present invention are not limited in use for the case where an interlayer adhesive film for the build-up type is employed and, needless to say, are applicable to general adhesive films having thermal flowability, for example, a dry film such as solder resist or the like.

The heat-resistant rubber roll with which the apparatus for vacuum lamination of the present invention is equipped is usually used after putting a rubber having a thickness of 1 to 10 mm on the surface of a metal roll. Therefore, when the depth of the concave parts or notch parts is from 0.5 mm to several millimeters at the maximum, the purpose is fully achieved. It is not necessary to maintain the depth exceeding the thickness of the rubber.

### EXAMPLES

The present invention will be explained more specifically with reference to Examples, but the present invention is not limited to them.

### [Adhesive film-Manufacturing Example 1]

A resin composition varnish was prepared by dissolving 20 parts of a liquid bisphenol A type epoxy resin ("Epikote 828EL" manufactured by Yuka Shell Epoxy Co., Ltd.), 20 parts of a brominated bisphenol A type epoxy resin ("YDB-500" manufactured by Tohto Kasei Co., Ltd.), 20 parts of a cresol novolak type epoxy resin ('EPICLON N-673" manufactured by Dainippon Ink & Chemicals, Incorporated) and 15 parts of a terminal epoxydated polybutadiene rubber ("Denalex R-45EPT" manufactured by Nagase Chemicals, Ltd.) into methyl ethyl ketone by heating with stirring, and then adding thereto 50 parts of a brominated phenoxy resin varnish (40% by weight of nonvolatile matter, "YPB-40-PXM40" manufactured by Tohto Kasei Co., Ltd.), and 4 parts of an adduct of 2,4-diamino-6-(2-methyl-1-imidazolylethyl)-1,3,5-triazine·isocyanuric acid as an epoxy curing agent, as well as 2 parts of finely divided silica, 4 parts of antimony trioxide and 5 parts of calcium carbonate. The varnish was applied with a die coater onto a polyethylene terephthalate film having a thickness of 25 µm to form a layer in such amount that the resulting layer had, after dried, a resin thickness of 70 µm, and was dried at 80 to 120°C (average 100°C). Then, the resulting film was wound up with putting a polyethylene film having a thickness of 25 µm on the resin surface to obtain a mother roll.
Thereafter, the roll was slit into a width of 502 mm, whereby a roll-shape adhesive film was obtained.

### [Adhesive film-Manufacturing Example 2]

A roll-shape adhesive film was obtained in the same manner as described in Adhesive film-manufacturing Example 1 with the exception that the supporting base film was changed from the polyethylene terephthalate film to a copper foil having a thickness of 18 µm.

### [Comparative Example 1]

Onto a patterned glass epoxy internal-layer circuit board of 510 x 340 mm (having a conductor thickness of 35 µm) was vacuum laminated the roll-shape adhesive film obtained in Adhesive film-Manufacturing Example 1 by means of a vacuum roll-type dry coater "VDFC-R06" manufactured by Hitachi Techno-Engineering Co., Ltd. The film was laminated on both the surfaces of the board by placing the circuit board having a width of 510 mm laterally toward the adhesive film having a width of 502 mm with positioning in such that the centers of the adhesive film and the circuit board almost come into line. The lamination was performed under the conditions of a rolling temperature of 100°C, a line pressure of 2 kgf/cm, a reduced pressure of 8 kPa or less, and a transferring rate of 0.5 m/minute. As a result, there occurred the inconvenience that the seeping resin from the edges of the film adhered to the heat-resistant rubber roll and, upon continuous repeated lamination, the resin powder adhered to the laminated board.

### [Example 1]

In a procedure similar to Comparative Example 1 where the roll-shape adhesive film obtained in Adhesive film-Manufacturing Example 1 was vacuum laminated on a patterned glass epoxy internal-layer circuit board of 510 x 340 mm by means of a vacuum roll-type dry coater "VDFC-R06" manufactured by Hitachi Techno-Engineering Co., Ltd., the heat-resistant rubber roll for lamination was subjected to the processing of removing the rubber at a width of 2 mm toward the inside and 2 mm toward the outside at each part from both the edges of the adhesive film and a depth of 1 mm around the outer part of the roll. Then, the film was laminated under the same conditions as described in Comparative Example 1. As a result, since the edge parts of the adhesive film scarcely received the pressure of the heat-resistant rubber roll, the resin hardly seeped out, so that continuous lamination could be effected clean.

### [Example 2]

In a procedure similar to Comparative Example 1 where the roll-shape adhesive film obtained in Adhesive film-Manufacturing Example 2 was vacuum laminated on a patterned glass epoxy internal-layer circuit board of 510 x 340 mm by means of a vacuum roll-type dry coater "VDFC-R06" manufactured by Hitachi Techno-Engineering Co. Ltd., the heat-resistant rubber roll for lamination was subjected to a processing of additionally putting a rubber having a thickness of 2 mm, a hardness of 70 and a width of 498 mm at a position of 2 mm toward the inside from both the edges of the adhesive film around the outer part of the roll. Then, the film was laminated under the same conditions as described in Comparative Example 1. As a result, since the edge parts of the adhesive film scarcely received the pressure of the heat-resistant rubber roll, the resin hardly seeped out, so that continuous lamination could be effected clean.

As shown in the result of Comparative Example 1, when an adhesive film is laminated in a conventional manner by means of a commercially available vacuum lamination machine, seepage of an adhesive makes the roll dirty. As is evident from the results of Examples 1 and 2, it is possible to laminate an adhesive film having thermal flowability continuously in a clean state according to the method of the present invention.

By means of an embodiment of the present invention, it is possible to laminate an adhesive film having thermal flowability on a circuit board conveniently without occurrence of fouling a laminating roll (a heat-resistant rubber roll) caused by seepage of the resin composition (adhesive). The present method can realize vacuum lamination with good productivity in a clean state.

## Claims

1. An apparatus for the vacuum lamination of an adhesive film wherein the resin composition layer of an adhesive film composed of a supporting base film and a resin composition layer which is thermally flowable and solid at room temperature, which is laminated on the surface of the base film and which has a width and an area substantially equal to those of the base film is vacuum-laminated continuously on a lamina under heating and pressing conditions by the use of a heat-resistant rubber roll wider than said adhesive film,
wherein
(a) said heat-resistant rubber roll has concave parts or notch parts corresponding to the width of the adhesive film to be placed and on the surfaces in the vicinity of both the ends of the roll, and
(b) said concave parts have a depth of at least 0.5 mm, its inner walls being respectively positioned at a distance within a range of 1 to 20 mm toward the inside from both the edges of the adhesive film, and its outer walls being respectively positioned at a distance of at least 1 mm toward the outside, or the walls of said notch parts being respectively positioned at a distance within a range of 1 to 20 mm toward the inside from both the edges of the adhesive film.

2. A method of vacuum lamination of an adhesive film wherein the resin composition layer of an adhesive film composed of a supporting base film and a resin composition layer which is thermally flowable and solid at room temperature, which is laminated on the surface of the base film and which has a width and an area substantially equal to those of the base film is continuously vacuum-laminated on a lamina under heating and pressing conditions by the use of a heat-resistant rubber roll wider than said adhesive film, said method having the steps of:
(a) positioning the concave parts having a width of 2 to 21 mm and a depth of at least 0.5 mm or notch parts having a depth of at least 0.5 mm provided on the surfaces in the vicinity of both the ends of said heat-resistant rubber roll are positioned in such a way that the inner walls of the concave parts or the walls of the notch parts are positioned on the outside of the patterned part of the circuit board,
(b) positioning both the edges of said adhesive film always on the outside of the inner wall of each concave part or the wall of each notch part, and in the case of the concave part, positioning both the edges of said adhesive film at least 1 mm away toward the inside from the outer wall of each concave part, and then
(c) vacuum-laminating the adhesive film.

3. An apparatus according to claim 1 or a method according to claim 2 wherein said lamina is a circuit board and the film is laminated on its patterned part.
